# FASCICULE DE BREVET EUROPEEN

(11) **EP 2 556 354 B1**
(45) Date de publication et mention de la délivrance du brevet: **23.10.2019**
(21) Numéro de dépôt: 11714961.7
(22) Date de dépôt: 07.04.2011
(51) Int. Cl.: G01L 9/00, H01H 29/18, G06F 3/041, H03K 17/96, G06F 3/045, G06F 3/044

(54) **DISPOSITIF FORMANT CAPTEUR DE PRESSION, PROCEDE DE REALISATION D'UN TEL CAPTEUR ET APPLICATION A LA REALISATION D'UN ECRAN TACTILE**
DRUCKSENSOR, VERFAHREN ZUR HERSTELLUNG EINES DERARTIGEN SENSORS UND SEINE VERWENDUNG ZUR HERSTELLUNG EINES BERÜHRUNGSEMPFINDLICHEN BILDSCHIRMES
PRESSURE SENSOR DEVICE, METHOD FOR MANUFACTURING SUCH A SENSOR AND USE OF SAME FOR PRODUCING A TOUCH-SENSITIVE SCREEN

(30) Priorité: 08.04.2010 FR 1052658
(43) Date de publication de la demande: 13.02.2013
(73) Titulaire: Commissariat à l'Énergie Atomique et aux Énergies Alternatives, 75015 Paris (FR)
(72) Inventeur: BENWADIH, Mohamed, F-94500 Champigny sur Marne (FR)
(74) Mandataire: Ilgart, Jean-Christophe
(86) Numéro de dépôt international: PCT/EP2011/055435
(87) Numéro de publication internationale: WO 2011/124647

(56) Documents cités:
- EP-A2- 0 262 507
- FR-A1- 2 428 823
- FR-A1- 2 876 215
- US-A- 3 903 389
- US-A- 6 122 972
- US-A1- 2004 029 425
- US-A1- 2008 060 441

## Description

### DOMAINE TECHNIQUE

L'invention concerne un dispositif formant capteur de pression comprenant un substrat en matériau isolant électrique.

L'invention concerne également un procédé de réalisation d'un tel capteur.

Une application particulièrement intéressante visée par l'invention est la réalisation d'un écran tactile.

### ÉTAT DE LA TECHNIQUE ANTÉRIEURE

De nombreux capteurs de pression sont connus à ce jour. De la manière la plus générale, on peut définir un capteur de pression comme étant l'élément qui va permettre sous l'effet d'une pression mécanique de délivrer un signal électrique exploitable par un circuit de commande.

Les capteurs de pression ont connu récemment un développement accru du fait de leur utilisation répandue en tant que partie d'un écran tactile. Un écran tactile permet en effet à un utilisateur d'accomplir différentes fonctions en exerçant une pression sur un panneau d'interface avec son doigt ou un stylet dans une zone précise indiquée par une interface graphique et/ou textuelle. En général, les écrans tactiles sont ainsi adaptés pour reconnaitre une pression déterminée dans une zone déterminée du panneau d'interface, et un circuit de commande relié à un système de traitement logiciel du signal électrique peuvent ainsi interpréter la pression déterminée en relation avec la zone d'interface graphique et/ou textuelle et ainsi déclencher des opérations désirées.

On peut citer ici les différentes réalisations commerciales de la société Apple et qui concernent des écrans tactiles comprenant une pluralité de capteurs de pression permettant de détecter la pression exercée sur une plaque de verre.

Dans leur application d'écran tactile, on peut classer en deux catégories différentes les capteurs de pression. Les capteurs de pression de type résistif comprennent deux plaques revêtues chacune de couches ou pluralité de plots en matériau conducteur électrique et séparées l'une de l'autre par une couche en matériau résistif. Lorsqu'une pression est exercée sur la plaque en interface avec l'extérieur les couches ou plots conducteurs métalliques entrent en contact par l'intermédiaire de la couche résistive ce qui induit une modification de la résistance électrique, cette modification électrique en une zone précise étant utilisée pour détecter où la pression a été exercée. Dans les capteurs de pression de type capacitif, des charges électriques sont accumulées sur une plaque de verre en interface avec l'extérieur. Lorsqu'une pression est exercée sur ladite plaque, un surplus de capacitance est induit. Ce surplus est mesurable. La répartition d'une pluralité de capteurs de pression sur toute la surface de la plaque permet de déterminer les coordonnées de la zone sur laquelle la pression a été exercée.

L'inventeur pense que pour différentes applications, il serait intéressant d'avoir un capteur de pression réalisé en technologie plastique, en particulier car elle permet d'envisager des substrats flexibles. En outre, l'inventeur pense qu'augmenter la sensibilité de tels capteurs de pression pourrait être intéressant.

Le but de l'invention est donc de proposer un nouveau type de capteur de pression pouvant être réalisé à partir d'une technologie plastique et dont la sensibilité peut être augmentée.

Un autre but de l'invention est de proposer un capteur de pression à partir duquel on peut réaliser un écran tactile.

Le document US 3903389 décrit un commutateur auto-encodeur et un clavier utilisant celui-ci.

Le document EP 262507 décrit un capteur de pression intégré, en matériau semi-conducteur.

Le document US 6122972 décrit un capteur de pression capacitif, avec un diélectrique déplaçable ou changeant de forme.

Le document US 2004/19425 décrit des contacts temporaires, conformes, pour des composants micro-électroniques.

### EXPOSÉ DE L'INVENTION

Pour ce faire, l'invention a pour objet un dispositif formant capteur de pression selon la revendication 1.

Grâce à l'invention, on peut réaliser un capteur de pression sur un substrat flexible en matériau plastique, tel que du polyéthylène naphtalate PEN avec une grande sensibilité.

Le temps de réponse d'un tel capteur de pression, c'est-à-dire le temps mis entre l'instant où la pression est exercée sur la membrane flexible, typiquement par le doigt d'un utilisateur, et l'instant de court-circuit entre les deux électrodes est détecté par un circuit de commande avec une unité de traitement logicielle, est très court. Dans la variante où le liquide est isolant électrique, on peut choisir un matériau de grande permittivité électrique qui permet d'obtenir une grande capacitance du capteur lors du court-circuit entre les deux électrodes.

Dans l'application d'un écran tactile, et où l'on envisage une pression exercée par un doigt d'un utilisateur, on prévoit un volume du premier et deuxième réservoirs de l'ordre de 5 mm³ pour le liquide, avec une distance entre les deux électrodes de l'ordre de 1mm et une tension appliquée entre les deux électrodes est de l'ordre de 0,5 Volt.

Pour améliorer encore la précision du capteur de pression selon l'invention, on peut envisager de réduire le volume du premier et deuxième réservoirs jusqu'à 10 mm³.

Le capteur de pression selon l'invention présente une grande reproductibilité de détection : en effet, le volume de liquide transféré (évacué) est une grandeur fixée par le volume initial déterminé dans le substrat, ce volume initial étant calibré et restant constant pendant toute la durée de vie du capteur.

Selon un mode de réalisation avantageux, le substrat isolant électrique a une épaisseur telle qu'il est flexible.

Le substrat isolant électrique est de préférence en matériau plastique, avantageusement choisi parmi les polyéthylènes, de préférence en polyéthylène naphtalate (PEN). Il peut être également choisi parmi les poliimides, tels le Kapton®, les polypropylènes, les polycarbonates.

On peut également envisager de le réaliser en céramique ou en silice.

Trois alternatives peuvent être envisagées pour le liquide :
- le liquide peut être conducteur électrique, tel que le polymère polyéthylènedioxythiophène (PDOT) ou la polyaniline ou un électrolyte: le court-circuit établi entre les deux électrodes se traduit alors par une variation de résistance,
- le liquide peut être isolant électrique: le court-circuit établi entre les deux électrodes se traduit alors par une variation de capacité,
- le liquide peut être semi-conducteur électrique tel que le polymère poly (styrène sulfonate) de sodium (PSS) : le court-circuit établi entre les deux électrodes se traduit alors soit par une variation de résistance, soit par une variation de capacité en fonction de la conductivité du liquide.

En d'autres termes, en sélectionnant uniquement la conductivité du liquide, on peut réaliser sort un capteur de type capacitif, soit un capteur de type résistif,

Selon une variante de réalisation, la membrane flexible est en matériau plastique, avantageusement en polyéthylène (PE).

Selon une autre variante de réalisation, la membrane est une feuille métallique recouverte d'un film isolant électrique.

Pour optimiser l'évacuation du liquide sous la poussée, le premier réservoir est selon l'invention de forme sensiblement complémentaire à l'excroissance à une cote près, ladite cote permettant au liquide d'être évacué du premier réservoir vers le deuxième réservoir lors de la poussée de l'excroissance. Cette dernière peut avoir ainsi une forme parallélépipédique.

Pour simplifier la réalisation, le premier réservoir et le deuxième réservoir sont jointifs, le deuxième réservoir étant au dessus du premier réservoir.

L'invention concerne également un procédé de réalisation d'un dispositif formant capteur de pression selon la revendication 10 et comprenant les étapes suivantes:
a/ réalisation d'un substrat en matériau isolant électrique comprenant un premier réservoir et une partie d'un deuxième réservoir en communication avec le premier réservoir,
b/ métallisation du fond du deuxième réservoir pour créer une première électrode et une partie d'une ligne de connexion électrique reliée à la première électrode,
c/ réalisation d'un membrane flexible en matériau isolant électrique, comprenant une excroissance,
d/ métallisation de la face de la membrane ou d'une couche en matériau isolant électrique solidaire de la membrane du côté de l'excroissance pour créer une deuxième électrode et une partie d'une deuxième ligne de connexion électrique reliée à la deuxième électrode,
e/ remplissage d'une partie du premier réservoir par un liquide,
f/ solidarisation de la membrane flexible au substrat afin d'avoir l'excroissance en regard du premier réservoir et de permettre son déplacement de entre une position dans laquelle elle est distante du liquide et au moins une deuxième position dans laquelle elle exerce une poussée sur le liquide en l'évacuant ainsi au moins en partie du premier réservoir vers le deuxième réservoir délimité par les deux électrodes, avec contact mécanique avec celles-ci, le premier réservoir étant de forme sensiblement complémentaire à l'excroissance à une cote près, ladite cote permettant au liquide d'être évacué du premier réservoir vers le deuxième réservoir lors de la poussée de l'excroissance, ledit contact mécanique du liquide avec les deux électrodes établissant une variation de résistance ou de capacité entre les deux électrodes.

Pour réaliser l'étape a/, on peut procéder par embossage ou gravage d'un substrat isolant électrique.

On réalise l'étape c/ de préférence par moulage, embossage ou gravage.

Avantageusement, après l'étape e/, on réalise une mise sous vide dans la partie du premier réservoir non remplie par le liquide et dans le deuxième réservoir. Réaliser le vide dans la partie des réservoirs non remplie par le liquide permet avantageusement d'éviter l'oxydation des électrodes, et donc, permet d'augmenter la durée de vie d'un capteur selon l'invention. Cette étape de mise sous vide peut être réalisée pendant l'étape f/ de solidarisation entre membrane flexible et substrat.

On peut réaliser l'étape f/ par collage de la membrane sur le substrat avec alignement. On peut également envisager toute autre technique telle que le scellement ou la soudure.

Le procédé décrit permet de réaliser une des deux électrodes solidaires de la membrane : ainsi, lorsqu'une pression est exercée sur la membrane, les caractéristiques dimensionnelles du deuxième réservoir sont également modifiées. Ainsi, la mesure de la variation de résistance ou de capacité entre les deux électrodes permet de déterminer précisément la valeur de la pression appliquée sur la membrane.

Dans le cas où les deux électrodes sont solidaires du substrat, les caractéristiques dimensionnelles du deuxième réservoir ne sont pas modifiées, et alors on obtient une variation de résistance ou de capacité binaire, c'est-à-dire, en tout ou rien selon que le contact mécanique entre liquide et électrodes est établi ou non.

L'invention concerne enfin un écran tactile selon la revendication 14 comprenant une pluralité de capteurs de pression décrit ci-dessus avec un seul substrat et une seule membrane, les capteurs étant agencés uniformément sur toute la surface selon un pas défini, une des deux électrodes de chaque capteur étant reliée à une des deux électrodes de tous les autres de la pluralité de capteurs en définissant des lignes (Li), l'autre des deux électrodes de chaque capteur étant reliée à l'autre des deux électrodes de tous les autres de la pluralité de capteurs en définissant des colonnes (Col), les lignes étant reliées à un potentiel électrique (L2) et les colonnes étant reliées à un potentiel électrique (L1) différent de celui des lignes.

### BRÈVE DESCRIPTION DES DESSINS

D'autres avantages et caractéristiques ressortiront mieux à la lecture de la description détaillée faite ci-dessous en référence aux figures suivantes parmi lesquelles :
- les figures 1A et 1B sont des vues schématiques en coupe transversale d'un capteur de pression selon l'invention dans une position respectivement où aucune pression n'est appliquée et où une pression est appliquée,
- la figure 1C est une vue schématique de dessus d'un capteur de pression selon les figures 1A et 1B montrant les connexions électriques des deux électrodes du capteur,

- les figures 2 à 11 sont des vues schématiques en coupe transversale montrant les différentes étapes de réalisation d'un capteur de pression selon l'invention,
- les figures 2A à 10A sont des vues schématiques de dessus correspondants aux figures 2 à 10 en coupe transversale,
- la figure 12 est une vue schématique de dessus d'un écran tactile comprenant une pluralité de capteur de pression selon l'invention agencés selon une matrice à pas régulier défini.

### EXPOSÉ DÉTAILLÉ DE MODES DE RÉALISATION PARTICULIERS

On précise que les termes « inférieur » et « supérieur » sont à utiliser en référence à la gravité. Ainsi, une électrode inférieure constitue une électrode de dessous et l'électrode supérieure constitue une électrode de dessus.

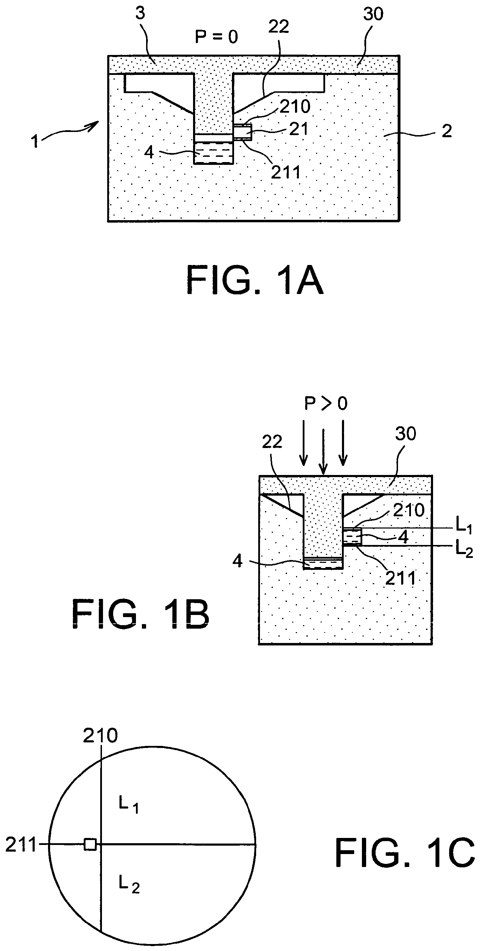

En figure 1A, on a représenté un dispositif formant capteur de pression 1 selon l'invention dans la position où aucune pression (P=0) n'est exercée dessus. Le capteur de pression 1 comprend un substrat en matériau isolant électrique 2 auquel est solidarisée une membrane flexible 3.

Le substrat 2 est de préférence sous la forme d'un film plastique tel qu'en PEN polyéthylène naphtalate avec une épaisseur le rendant flexible (e de l'ordre de 125 µm par exemple).

Le substrat 1 comprend un premier réservoir 20 rempli en partie d'un liquide 4. Un deuxième réservoir 21 est jointif au premier réservoir 20 en étant agencé au dessus. Ce deuxième réservoir 21 comprend sur ses parois internes inférieure et supérieure deux électrodes 210, 211.

La membrane flexible 3 comprend une excroissance 30 de forme parallélépipédique telle qu'illustrée en figure 1A, cette forme étant sensiblement complémentaire à celle du premier réservoir 20 à une cote près. La membrane est dans l'exemple décrit en polyéthylène (PE). La solidarisation de la membrane flexible 3 et du substrat 2 est telle que l'excroissance est en regard et à l'aplomb du premier réservoir 20 en l'absence de toute pression, et à distance du liquide 4 (figure 1A).

En cas de pression exercée sur la membrane 3 (P>O), celle-ci prend une position dans laquelle l'excroissance 30 pousse le liquide en l'évacuant au moins en partie du premier réservoir 20 vers le deuxième réservoir 21 avec un contact mécanique entre les deux électrodes 210, 211. Ce contact mécanique du liquide 4 avec les deux électrodes 210, 211 établit un court-circuit entre elles.

Chaque électrode 210, 211 est reliée à une ligne de connexion électrique L1, L2 à un potentiel électrique différent (figure 1C).

Le liquide 4 est dans l'exemple décrit un polymère conducteur électronique tel qu'un polyéthylènedioxythiophène (PDOT) ou la polyaniline.

Le capteur de pression représenté 1 est un capteur de pression de type résistif car le court-circuit entre les deux électrodes 210, 211 crée une résistance électrique

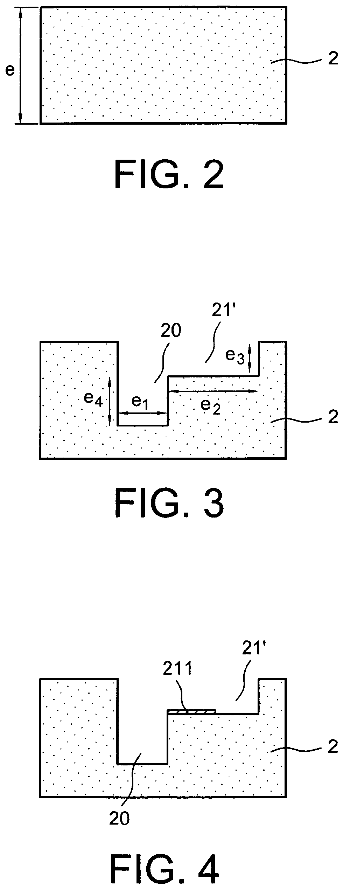

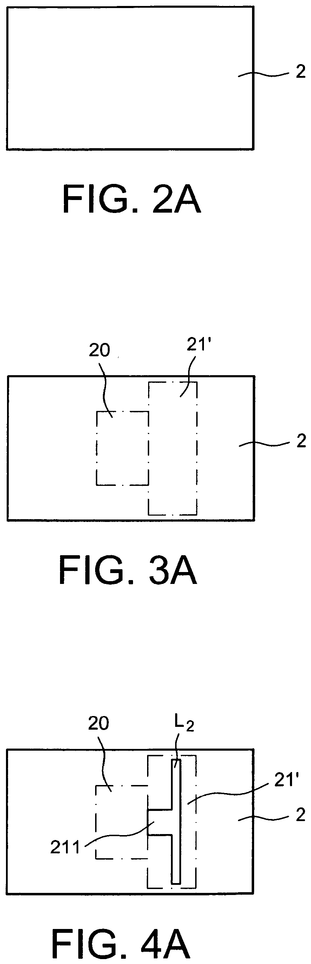

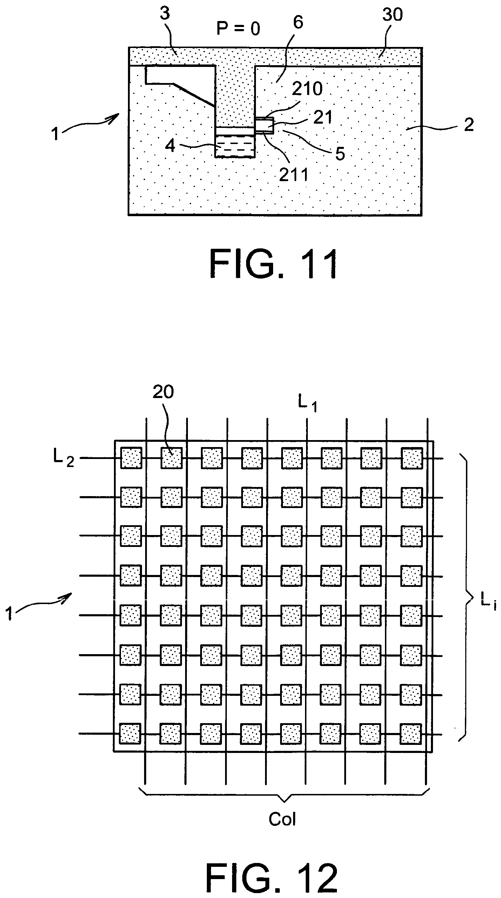

Les différentes étapes de réalisation d'un capteur de pression selon l'invention sont représentées aux figures 3 et 11, et aux figures 3A et 11A en vue de dessus correspondantes.

En partant d'un substrat 2 en matériau flexible, tel que du PEN, d'épaisseur e de l'ordre de 125 µm par exemple (figures 2 et 2A), on réalise tout d'abord une étape d'embossage ou de gravage de ce substrat 2 pour obtenir le premier réservoir 20 et une partie du deuxième réservoir 21' (figures 3 et 3A) jointifs l'un à l'autre.

Pour un capteur de grande précision, réalisé par gravage par lithographie, on peut prévoir des dimensions e1 à e4, telles qu'illustrées en figure 3, dans les gammes suivantes :
- e1 de 1 µm à 3 µm ;
- e2 de 1 µm à 3 µm ;
- e3 de 100 nm à 1 µm;
- e4 de 100 nm à 1 µm.

De même, pour un capteur de grande précision, réalisé par embossage, on peut prévoir des dimensions e1 à e4 dans les gammes suivantes :
- e1 de 10 µm à 500 µm ;
- e2 de 1 µm à 500 µm ;
- e3 de 100 nm à 10 µm;
- e4 de 1 µm à 100 µm.

On précise ici que les dimensions e1 et e4 représentent respectivement la largeur et hauteur du premier réservoir 20 et e2 et e3 respectivement la largeur et hauteur du deuxième réservoir 21.

Avantageusement, on prévoit une forme 22 de rélisation du substrat à l'entrée du premier réservoir pour supprimer tout angle vif. Telle que représentée aux figures 1A et 1B, cetet forme 22 est une forme tronconique. Ainsi, la membrane 3 du capteur ne vient pas s'appuyer sur un angle vif lorsqu'une pression P est appliquée : cela lui donne plus de flexibilité et d'amplitude. En outre, cela permet de ne pas dégrader la membrane de manière prématurée : en d'autres termes, on augmente ainsi sa durée de vie.

En fonction de la précision recherchée du capteur selon l'invention et donc des dimensions voulues, l'une ou l'autre des techniques (embossage ou gravage par lithographie) sera privilégiée.

Puis on réalise une étape de métallisation du fond du réservoir 21' afin d'obtenir une électrode 211 et une ligne de connexion électrique L2 (figures 4 et 4A).

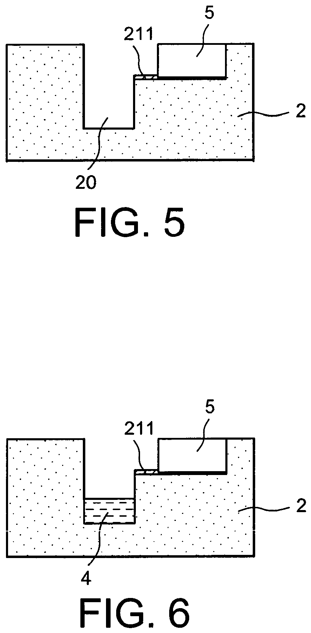

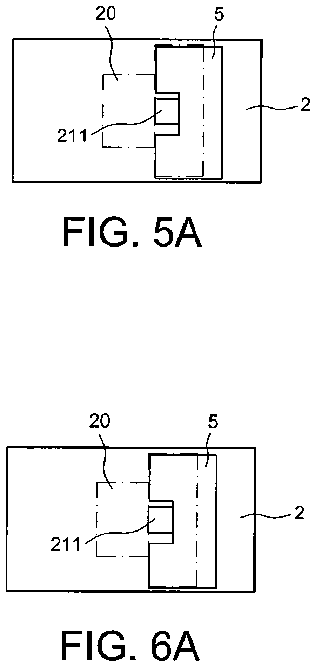

On dépose alors une couche isolant électrique pour isoler la ligne de connexion électrique de la partie du deuxième réservoir 21' (figures 5 et 5A).

On remplit alors le premier réservoir 20 du liquide 4 dans une quantité prédéterminée (figures 6 et 6A). Il s'agit d'un polymère conducteur électronique tel qu'un polyéthylènedioxythiophène (PDOT) ou la polyaniline dans l'exemple décrit.

Parallèlement à ces étapes de réalisation du substrat flexible 2 en PEN qui viennent d'être décrite on réalise la membrane flexible.

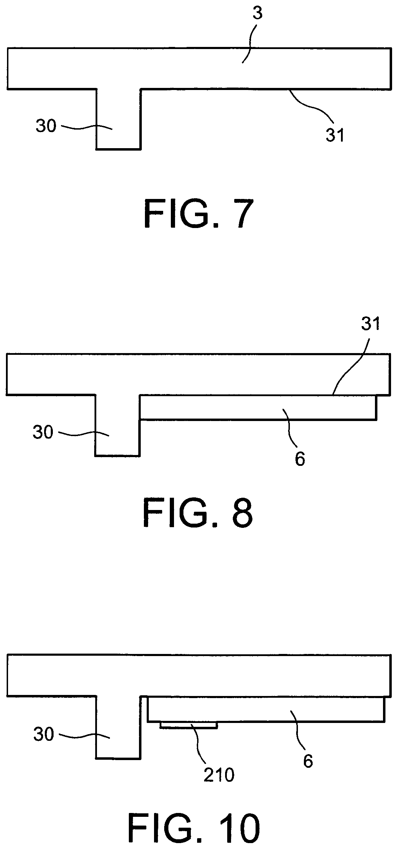

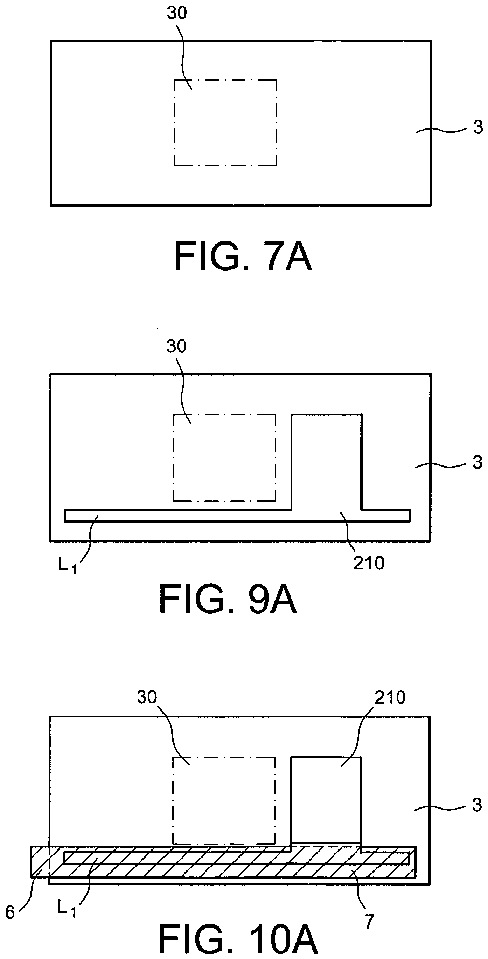

On réalise ainsi tout d'abord de préférence par moulage, embossage ou gravage, une membrane flexible 3 en PE avec une excroissance 30 de forme sensiblement complémentaire avec celle du premier réservoir 20 (figures 7 et 7A).

On dépose alors du côté de la face 31 de l'excroissance une couche isolante électrique 6 pour isoler l'électrode 210 métallisée par la suite (figure 8) .

On réalise alors l'étape proprement dite de métallisation sur la couche isolante électrique 6 pour obtenir la deuxième électrode 210 et une ligne de connexion électrique L1 (figure 9A).

On dépose ensuite une autre couche isolante 7 pour isoler électriquement la ligne L1 de connexion électrique (figures 10 et 10A).

Une fois le substrat flexible réalisé et le premier réservoir rempli en partie par le liquide 4 (figures 6 et 6A) et la membrane flexible réalisée (figures 10 et 10A), on réalise alors une étape de solidarisation de la membrane 3 sur le substrat 2 avec un alignement pour mettre respectivement l'excroissance 30 en regard et à l'aplomb du premier réservoir 20 et les deux électrodes 210 et 211 en regard l'une de l'autre (figure 11).

Dans l'exemple représenté, le volume de liquide remplissant le premier réservoir 20 est de l'ordre de 5 mm³. En fonction de la précision et des dimensions e1 à e4 choisies, on peut déterminer un volume de liquide compris entre 100 pL et 10 mm³. Pendant l'étape de solidarisation (assemblage) entre membrane et substrat, on réalise une mise sous vide de la partie des premier 20 et deuxième 21 réservoirs : on évite ainsi l'oxydation des électrodes 210, 211, et donc on augmente la durée de vie du capteur selon l'invention.

Pour réaliser un écran tactile on réalise une pluralité de capteurs de pression avec un seul substrat 2 et une seule membrane 3, les capteurs étant agencés uniformément sur toute la surface selon un pas défini comme représenté en figure 12. Ainsi, une électrode 210 des deux électrodes de chaque capteur 1 est reliée à une électrode 210 des deux électrodes de tous les autres de la pluralité de capteurs en définissant des lignes géométriques Li par les lignes de connexions électriques L2. L'autre électrode 211 des deux électrodes de chaque capteur étant reliée à l'autre électrode 211 des deux électrodes de tous les autres de la pluralité de capteurs en définissant des colonnes géométriques Col par les lignes de connexions électriques L1.

Les lignes L2 sont reliées à un potentiel électrique et les colonnes L1 sont reliées à un potentiel électrique différent de celui des lignes.

Autrement dit, en répétant la structure du capteur de pression 1 selon l'invention sur toute la surface d'un écran à un pas défini on peut recouvrir toute cette surface et ainsi la pixéliser.

On peut ainsi connaître avec précision si une pression a été exercée sur l'écran tactile et dans quelle zone précise elle a été exercée.

D'autres améliorations et applications peuvent être réalisées sans pour autant sortir du cadre de l'invention.

Ainsi, si le capteur de pression 1 décrit ci-dessus l'est en référence à la réalisation d'un écran tactile, il peut tout aussi bien être utilisé dans une autre application.

## Revendications

1. Dispositif (1) formant capteur de pression comprenant :
- un substrat (2) en matériau isolant électrique comprenant un premier réservoir (20), un deuxième réservoir (21) en communication avec le premier réservoir,
**caractérisé en ce que** :
- deux parois internes du deuxième réservoir (21) sont munies chacune d'une électrode (210, 211),
- une membrane flexible (3) en matériau isolant électrique, comprenant une excroissance (30), est solidarisée au substrat pour permettre le déplacement de l'excroissance entre une position dans laquelle elle est distante d'un liquide (4) remplissant au moins en partie le premier réservoir et au moins une deuxième position dans laquelle elle exerce une poussée sur le liquide en l'évacuant ainsi au moins en partie du premier réservoir vers le deuxième réservoir avec contact mécanique avec les deux électrodes, le premier réservoir étant de forme sensiblement complémentaire à l'excroissance à une cote près, ladite cote permettant au liquide d'être évacué du premier réservoir vers le deuxième réservoir lors de la poussée de l'excroissance, ledit contact mécanique du liquide avec les deux électrodes établissant une variation de résistance ou de capacité entre les deux électrodes.

2. Capteur de pression selon la revendication 1, dans lequel le substrat isolant électrique a une épaisseur telle qu'il est flexible.

3. Capteur de pression selon la revendication 1 ou 2, dans lequel le substrat isolant électrique et/ou la membrane flexible est en matériau plastique.

4. Capteur de pression selon la revendication 3, dans lequel le substrat isolant électrique est choisi parmi les polyéthylènes, de préférence en polyéthylène naphtalate (PEN).

5. Capteur de pression selon la revendication 3, dans lequel la membrane flexible est en polyéthylène (PE).

6. Capteur de pression selon l'une des revendications précédentes, dans lequel le liquide est :
- conducteur électrique, tel que le polymère polyéthylènedioxythiophène (PDOT) ou la polyaniline ou un électrolyte ;
- ou est semi-conducteur électrique tel que le polymère poly (styrène sulfonate) de sodium (PSS) ;
- ou est isolant électrique.

7. Capteur de pression selon l'une des revendications 1 à 6, dans lequel la membrane est une feuille métallique recouverte d'un film isolant électrique.

8. Capteur de pression selon l'une des revendications précédentes, dans lequel l'excroissance a une forme parallélépipédique.

9. Capteur de pression selon l'une des revendications précédentes, dans lequel le premier réservoir et le deuxième réservoir sont jointifs, le deuxième réservoir étant au dessus du premier réservoir.

10. Procédé de réalisation d'un dispositif formant capteur de pression (1) comprenant les étapes suivantes:
a/ réalisation d'un substrat (2) en matériau isolant électrique comprenant un premier réservoir (20) et une partie (21') d'un deuxième réservoir en communication avec le premier réservoir,
b/ métallisation du fond du deuxième réservoir pour créer une première électrode (211) et une partie d'une ligne de connexion électrique (L2) reliée à la première électrode,
c/ réalisation d'une membrane flexible (3) en matériau isolant électrique, comprenant une excroissance (30),
d/ métallisation de la face (31) de la membrane ou d'une couche (6) en matériau isolant électrique solidaire de la membrane du côté de l'excroissance pour créer une deuxième électrode (210) et une partie d'une deuxième ligne de connexion électrique reliée à la deuxième électrode,
e/ remplissage d'une partie du premier réservoir par un liquide (4),
f/ solidarisation de la membrane flexible au substrat afin d'avoir l'excroissance en regard du premier réservoir et de permettre son déplacement de entre une position dans laquelle elle est distante du liquide et au moins une deuxième position dans laquelle elle exerce une poussée sur le liquide en l'évacuant ainsi au moins en partie du premier réservoir vers le deuxième réservoir délimité par les deux électrodes, avec contact mécanique avec celles-ci, le premier réservoir étant de forme sensiblement complémentaire à l'excroissance à une cote près, ladite cote permettant au liquide d'être évacué du premier réservoir vers le deuxième réservoir lors de la poussée de l'excroissance, ledit contact mécanique du liquide avec les deux électrodes établissant une variation de résistance ou de capacité entre les deux électrodes.

11. Procédé selon la revendication 10, selon lequel on réalise l'étape a/ par embossage ou gravage d'un substrat isolant électrique et/ou l'étape c/ par moulage, embossage ou gravage.

12. Procédé selon l'une des revendications 10 ou 11, selon lequel après l'étape e/, on réalise une mise sous vide dans la partie du premier réservoir non remplie par le liquide et dans le deuxième réservoir.

13. Procédé selon l'une des revendications 10 à 12, selon lequel on réalise l'étape f/ par collage de la membrane sur le substrat avec alignement.

14. Ecran tactile comprenant une pluralité de capteurs de pression (1) selon l'une des revendications 1 à 9, avec un seul substrat (2) et une seule membrane (3), les capteurs étant agencés uniformément sur toute la surface selon un pas défini, une des deux électrodes de chaque capteur étant reliée à une des deux électrodes de tous les autres de la pluralité de capteurs en définissant des lignes (Li), l'autre des deux électrodes de chaque capteur étant reliée à l'autre des deux électrodes de tous les autres de la pluralité de capteurs en définissant des colonnes (Col), les lignes étant reliées à un potentiel électrique et les colonnes étant reliées à un potentiel électrique différent de celui des lignes.

## Patentansprüche

1. Vorrichtung (1) zur Bildung eines Drucksensors, umfassend:
- ein Substrat (2) aus einem elektrisch isolierenden Material, umfassend ein erstes Reservoir (20) und ein zweites Reservoir (21) in Kommunikation mit dem ersten Reservoir,
**dadurch gekennzeichnet, dass**:
- zwei Innenwände des zweiten Reservoirs (21) jeweils mit einer Elektrode (210, 211) ausgestattet sind,
- eine flexible Membran (3) aus einem elektrisch isolierenden Material, umfassend eine Ausbuchtung (30), mit dem Substrat verbunden ist, um die Verlagerung der Ausbuchtung zu ermöglichen zwischen einer Position, in der sie von einer Flüssigkeit (4) entfernt ist, mit der das erste Reservoir wenigstens teilweise gefüllt ist, und wenigstens einer zweiten Position, in der sie einen Druck auf die Flüssigkeit ausübt, wobei sie sie wenigstens teilweise von dem ersten Reservoir in Richtung des zweiten Reservoirs mit mechanischem Kontakt zwischen den zwei Elektroden evakuiert, wobei das erste Reservoir bis auf eine Seite eine im Wesentlichen zu der Ausbuchtung komplementäre Form hat, wobei die Seite es der Flüssigkeit ermöglicht, von dem ersten Reservoir in Richtung des zweiten Reservoirs während des Drucks der Ausbuchtung evakuiert zu werden, wobei der mechanische Kontakt der Flüssigkeit mit den zwei Elektroden eine Variation des Widerstands oder der Kapazität zwischen den zwei Elektroden bewirkt.

2. Drucksensor nach Anspruch 1, bei dem das elektrisch isolierende Substrat eine derartige Dicke hat, dass es flexibel ist.

3. Drucksensor nach Anspruch 1 oder 2, bei dem das elektrisch isolierende Substrat und/oder die flexible Membran aus einem Kunststoffmaterial ist.

4. Drucksensor nach Anspruch 3, bei dem das elektrisch isolierende Substrat ausgewählt ist aus den Polyethylenen, vorzugsweise aus Polyethylennaphthalat (PEN).

5. Drucksensor nach Anspruch 3, bei dem die flexible Membran aus Polyethylen (PE) ist.

6. Drucksensor nach einem der vorhergehenden Ansprüche, bei dem die Flüssigkeit folgendes ist:
- elektrisch leitend, beispielsweise das Polymer Polyethylendioxithiophen (PDOT) oder Polyanilin oder ein Elektrolyt;
- oder elektrisch halbleitend ist, beispielsweise das Polymer Natriumpoly(styrolsulfonat) (PSS);
oder elektrisch isolierend ist.

7. Drucksensor nach einem der Ansprüche 1 bis 6, bei dem die Membran ein metallisches Blatt ist, das mit einem elektrisch isolierenden Film bedeckt ist.

8. Drucksensor nach einem der vorhergehenden Ansprüche, bei dem die Ausbuchtung eine Parallelepipedform hat.

9. Drucksensor nach einem der vorhergehenden Ansprüche, bei dem das erste Reservoir und das zweite Reservoir aneinandergesetzt sind, wobei das zweite Reservoir über dem ersten Reservoir ist.

10. Verfahren zur Herstellung einer Vorrichtung zum Bilden eines Drucksensors (1), umfassend die folgenden Schritte:
a/ Herstellen eines Substrats (2) aus einem elektrisch isolierendem Material, umfassend ein erstes Reservoir (20) und einen Teil (21') eines zweiten Reservoirs in Kommunikation mit dem ersten Reservoir,
b/ Metallisieren des Bodens des zweiten Reservoirs zum Erzeugen einer ersten Elektrode (211) und eines Teils einer elektrischen Verbindungsleitung (L2), die mit der ersten Elektrode verbunden ist,
c/ Herstellen einer flexiblen Membran (3) aus einem elektrisch isolierenden Material, umfassend eine Ausbuchtung (30),
d/ Metallisieren der Fläche (31) der Membran oder einer Schicht (6) aus elektrisch isolierendem Material, die mit der Membran verbunden ist, an der Seite der Ausbuchtung, um eine zweite Elektrode (210) und einen Teil einer zweiten elektrischen Verbindungsleitung zu erzeugen, die mit der zweiten Elektrode verbunden ist,
e/ Füllen eines Teils des ersten Reservoirs mit einer Flüssigkeit (4),
f/ Verbinden der flexiblen Membran mit dem Substrat, um die Ausbuchtung gegenüber dem ersten Reservoir zu haben und ihre Verlagerung zu ermöglichen zwischen einer Position, in der sie von der Flüssigkeit entfernt ist, und wenigstens einer zweiten Position in der sie einen Druck auf die Flüssigkeit ausübt und sie somit wenigstens teilweise von dem ersten Reservoir in Richtung des zweiten Reservoirs evakuiert, das durch die zwei Elektroden begrenzt ist, mit mechanischem Kontakt mit diesen, wobei das erste Reservoir bis auf eine Seite eine zu der Ausbuchtung im Wesentlichen komplementäre Form hat, wobei die Seite es der Flüssigkeit ermöglicht, von dem ersten Reservoir in Richtung des zweiten Reservoirs während des Drucks der Ausbuchtung evakuiert zu werden, wobei der mechanische Kontakt der Flüssigkeit mit den zwei Elektroden eine Variation des Widerstands oder der Kapazität zwischen den zwei Elektroden bewirkt.

11. Verfahren nach Anspruch 10, bei dem man den Schritt a/ durch Prägen oder Gravieren eines elektrisch isolierenden Substrats realisiert, und/oder den Schritt c/ durch Formen, Prägen, oder Gravieren.

12. Verfahren nach einem der Ansprüche 10 oder 11, bei dem man nach dem Schritt e/ eine Evakuierung in dem Teil des ersten Reservoirs realisiert, der nicht mit der Flüssigkeit gefüllt ist, sowie in dem zweiten Reservoir.

13. Verfahren nach einem der Ansprüche 10 bis 12, bei dem man den Schritt f/durch Kleben der Membran auf das Substrat mit Ausrichtung realisiert.

14. Berührungsempfindlicher Bildschirm, umfassend eine Mehrzahl von Drucksensoren (1) nach einem der Ansprüche 1 bis 9, mit einem einzigen Substrat (2) und einer einzigen Membran (3), wobei die Sensoren gleichmäßig auf der gesamten Oberfläche gemäß einer definierten Teilung angeordnet sind, wobei eine der zwei Elektroden von jedem Sensor mit einer der zwei Elektroden von allen anderen von der Mehrzahl von Sensoren verbunden ist, wodurch Zeilen (Li) definiert werden, wobei die andere der zwei Elektroden von jedem Sensor verbunden ist mit der anderen der zwei Elektroden von allen anderen von der Mehrzahl von Sensoren wodurch Spalten (Col) definiert werden, wobei die Zeilen mit einem elektrischen Potenzial verbunden sind und die Spalten mit einem elektrischen Potential verbunden sind, das von jenem der Zeilen verschieden ist.

## Claims

1. Device (1) forming a pressure sensor including:
- a substrate (2) made of electrical insulation material including a first reservoir (20), a second reservoir (21) in communication with the first reservoir,
**Characterized in that**:
- two internal walls of the second reservoir (21) are each equipped with an electrode (210, 211);
- a flexible membrane (3) made of an electrical insulation material, including a protuberance (30) and secured to the substrate so as to enable the movement of the protuberance between a position in which it is at a distance from a liquid (4) at least partly filling the first reservoir and at least one second position in which it exerts a pressure on the liquid, thus discharging it at least partially from the first reservoir toward the second reservoir with mechanical contact with the two electrodes, the first reservoir having a shape substantially complementary to the protuberance except on a short distance, said short distance enabling the liquid to be discharged from the first reservoir toward the second reservoir when pressure is applied on the protuberance, said mechanical contact of the liquid with the two electrodes establishing a resistance or capacitance between the two electrodes.

2. Pressure sensor according to claim 1, wherein the electric insulation substrate has such a thickness that it is flexible.

3. Pressure sensor according to claim 1 or 2, wherein the electric insulation substrate and/or flexible membrane is made of plastic material.

4. Pressure sensor according to claim 3, wherein the electric insulation substrate is chosen from the polyethylenes, preferably polyethylene naphthalate (PEN).

5. Pressure sensor according to claim 3, wherein the flexible membrane is in polyethylene (PE).

6. Pressure sensor according to claim 1 or 2, wherein the liquid is:
- electrically conductive, such as the polyethylenedioxythiophene (PDOT) polymer or polyaniline or an electrolyte;
- or is electrically semiconductive, such as the sodium poly(styrene sulfonate) (PSS) polymer;
- or is electrically insulating.

7. Pressure sensor according to one of claims 1 to 6, wherein the membrane is a metal sheet covered with an electric insulation film.

8. Pressure sensor according to one of the preceding claims, wherein the protuberance has a parallelepiped shape.

9. Pressure sensor according to one of the preceding claims, wherein the first reservoir and the second reservoir are joined, with the second reservoir being above the first reservoir.

10. Method for producing a device forming a pressure sensor (1) including the following steps:
a) production of a substrate (2) made of an electric insulation material including a first reservoir (20) and a portion (21') of a second reservoir in communication with the first reservoir,
b) metallization of the base of the second reservoir to create a first electrode (211) and a portion of an electrical connection line (L2) connected to the first electrode,
c) production of a flexible membrane (3) made of an electric insulation material, including a protuberance (30),
d) metallization of the face (31) of the membrane or a layer (6) made of an electric insulation material secured to the membrane on the side of the protuberance so as to create a second electrode (210) and a portion of a second electrical connection line connected to the second electrode,
e) filling of a portion of the first reservoir by a liquid (4),
f) securing of the flexible membrane to the substrate so as to have the protuberance opposite the first reservoir and enable the movement thereof between a position in which it is at a distance from the liquid and at least one second position in which it exerts a pressure on the liquid, thus discharging it at least partially from the first reservoir toward the second reservoir delimited by the two electrodes, with mechanical contact with them, the first reservoir having a shape substantially complementary to the protuberance except on a short distance, said short distance enabling the liquid to be discharged from the first reservoir toward the second reservoir when pressure is applied on the protuberance, said mechanical contact of the liquid with the two electrodes establishing a variation in resistance or capacitance between the two electrodes.

11. Method according to claim 10, wherein step a) is performed by embossing or etching an electric insulation substrate and/or step c) is performed by molding, embossing or etching.

12. Method according to one of claims 10 or 11, wherein, after step e), a vacuum is created in the portion of the first reservoir not filled with the liquid and in the second reservoir.

13. Method according to one of claims 10 to 12, wherein, step f) is performed by bonding the membrane onto the substrate with alignment.

14. Touch screen including a plurality of pressure sensors (1) according to one of claims 1 to 9, with a single substrate (2) and a single membrane (3), with the sensors being arranged uniformly over the entire surface according to a defined pitch, one of the two electrodes of each sensor being connected to one of the two electrodes of all of the others of the plurality of sensors by defining lines (Li), the other of the two electrodes of each sensor being connected to the other of the two electrodes of all of the others of the plurality of sensors by defining columns (Col), the lines being connected to an electric potential and the columns being connected to an electric potential different from that of the lines.
